# EUROPÄISCHE PATENTSCHRIFT

(11) **EP 2 132 795 B1**
(45) Veröffentlichungstag und Bekanntmachung des Hinweises auf die Patenterteilung: **30.11.2011**
(21) Anmeldenummer: 08716934.8
(22) Anmeldetag: 19.02.2008
(51) Int. Cl.: H01L 41/083, H01L 41/047, H01L 41/22

(54) **PIEZOAKTOR UND VERFAHREN ZUM HERSTELLEN EINES PIEZOAKTORS**
PIEZOELECTRIC ACTUATOR AND METHOD FOR PRODUCING A PIEZOELECTRIC ACTUATOR
ACTIONNEUR PIÉZOÉLECTRIQUE ET PROCÉDÉ DE FABRICATION D'UN ACTIONNEUR PIÉZOÉLECTRIQUE

(30) Priorität: 20.02.2007 DE 102007008266
(43) Veröffentlichungstag der Anmeldung: 16.12.2009
(73) Patentinhaber: Continental Automotive GmbH, 30165 Hannover (DE)
(72) Erfinder: DORNER-REISEL, Annett, 09117 Chemnitz (DE)
(86) Internationale Anmeldenummer: PCT/EP2008/051984
(87) Internationale Veröffentlichungsnummer: WO 2008/101919

(56) Entgegenhaltungen:
- EP-A- 1 511 092
- JP-A- 2003 037 308
- US-A1- 2006 076 650

## Beschreibung

Die Erfindung betrifft einen vollaktiven Piezoaktor und ein Verfahren zum Herstellen eines vollaktiven Piezoaktors.

Piezoelemente werden u.A. für Positionierelemente, Ultraschallwandler, Sensoren und in Tintenstrahldruckern verwendet. Die Funktion eines Piezoelements beruht auf der Deformation piezokeramischer Materialien, wie z.B. Blei-Zirkonat-Titanat, unter Einwirkung eines elektrischen Feldes. Wird an das Piezoelement eine elektrische Spannung angelegt, so dehnt sich dieses in senkrechter Richtung zum erzeugten elektrischen Feld aus (inverser Piezo-Effekt).

Die DE 198 02 302 A1 offenbart einen mehrschichtigen Aktor-Aufbau. Ein derartiger mehrschichtiger Aktor besteht aus piezokeramischen Schichten und Innenelektroden zur Generierung des elektrischen Feldes. Da eine Vielzahl der piezokeramischen Schichten und Innenelektroden übereinander gestapelt sind, wird ein derartiger Aktor auch als "Stack" bezeichnet.

Die Innenelektroden kontaktieren zwei an der Außenseite des Piezostapels aufgetragene Außenelektroden, wobei die Innenelektroden abwechselnd nur eine der beiden Außenelektroden kontaktieren. Damit dies möglich ist, sind die Innenelektroden in den Bereichen, in denen sie die relevante Außenelektrode nicht kontaktieren sollen, nicht bis an die Außenseite des Piezostapels geführt. Diese Bereiche werden als inaktive Zonen bezeichnet, da die piezoelektrischen Schichten in den inaktiven Zonen bei einer an den Außenelektroden angelegten Spannung nicht vollständig vom elektrischen Feld der Innenelektroden durchsetzt werden und sich daher auch nicht bzw. im Vergleich zu den restlichen Bereichen des Piezostapels wenig ausdehnen. Dies führt innerhalb des Piezostapels zu mechanischen Spannungen, die den Piezostapel schädigen.

Aus der JP 2003-037308 ist ein vollaktiver Piezostapel bekannt. Dessen Innenelektroden sind aus zwei verschiedenen Materialien hergestellt, die abwechselnd an die Seitenkante des Stapels angrenzen. Zur alternierenden Kontaktierung mit einer Außenelektrode werden selektiv Seitenflächen des einen Innenelektrodenmaterials mit einer Isolationsschicht versehen, während Innenelektroden aus dem anderen Material frei bleiben. Ein weiterer Piezostapel mit Innenelektroden aus zwei verschiedenen Materialien ist aus der US 2006/0076650 A1 bekannt. Hierbei werden vor der Kontaktierung mit einer Außenelektrode einzelne Innenelektroden aufgrund magnetischer Wechselwirkung selektiv mit Isolationsmaterial beschichtet.

Die Aufgaben der Erfindung sind, einen Piezoaktor aus einem Piezostapel und ein Verfahren zum Herstellen eines Piezoaktors aus einem Piezostapel anzugeben, bei dem mechanische Spannungen im Betrieb des Piezoaktors wesentlich verringert sind.

Die Aufgabe der Erfindung wird gelöst durch ein Verfahren zum Herstellen eines vollaktiven Piezoaktors, aufweisend folgende Verfahrensschritte:
- Bereitstellen eines vollaktiven Piezostapels, der abwechselnd aufeinanderfolgende piezoelektrische Schichten und bis an die Außenseite des Piezostapels durchgehende Innenelektroden aufweist, wobei die Innenelektroden jeweils einen für eine Beschichtung schlecht oder nicht haftenden ersten Bereich und einen für die Beschichtung gut haftenden zweiten Bereich aufweisen und vorgesehen sind, abwechselnd eine erste und eine zweite Außenelektrode des Piezoaktors mit ihren ersten Bereichen zu kontaktieren,
- vollständiges Beschichten der Außenseite des vollaktiven keramischen Piezostapels mit der Beschichtung zumindest in Bereichen, denen die Außenelektroden des Piezoaktors zugeordnet sind,
- Entfernen der Beschichtung in Bereichen, die an die ersten Bereiche der Innenelektroden grenzen, und
- Auftragen der beiden Außenelektroden auf die Beschichtung, so dass die Außenelektroden die ersten Bereiche der Innenelektroden kontaktieren und ansonsten zwischen den Innenelektroden und den Außenelektroden die Beschichtung angeordnet ist.

Die Aufgabe der Erfindung wird auch gelöst durch einen Piezoaktor, aufweisend erste und zweite Außenelektrode, einen vollaktiven Piezostapel, der abwechselnd aufeinanderfolgende piezoelektrische Schichten und bis an die Außenseite des Piezostapels durchgehende Innenelektroden aufweist, wobei die Innenelektroden jeweils einen für eine Beschichtung schlecht oder nicht haftenden ersten Bereich und einen für die Beschichtung gut haftenden zweiten Bereich aufweisen und abwechselnd die erste und die zweite Außenelektrode mit ihren ersten Bereichen kontaktieren, und eine auf der Außenseite des Piezostapels angeordnete Beschichtung, auf der die Außenelektroden aufgetragen sind und die in Bereichen, in denen die Außenelektroden die Innenelektroden kontaktieren, entfernt ist, so dass die Außenelektroden die ersten Bereiche der Innenelektroden kontaktieren und ansonsten zwischen den Innenelektroden und den Außenelektroden die Beschichtung angeordnet ist, wobei die Innenelektroden an ihren zweiten Bereichen ein als Karbidbildner ausgebildetes Material aufweisen.

Für das erfindungsgemäße Verfahren bzw. für den erfindungsgemäßen Piezoaktor wird ein vollaktiver Piezostapel verwendet. Die Innenelektroden eines vollaktiven Piezostapels sind durchgehend, d.h. sie erstrecken sich über die gesamte Querschnittsfläche des Piezostapels. Durch diese Ausgestaltung reichen die gesamten Innenelektroden bis an die Außenseite des Piezostapels, weshalb dieser keine inaktiven Zonen aufweist. Dadurch wird die Höhe der mechanischen Spannungen innerhalb des Piezostapels während des Betriebs verringert.

Der bereitgestellte Piezostapel wird beispielsweise durch alternierendes Stapeln von wenigstens zwei Teilstapeln hergestellt, wobei jeder der Teilstapel eine piezoelektrische Schicht und eine darauf angeordnete Innenelektrode aufweist. Der bereitgestellte Piezostapel wird dabei insbesondere hergestellt, indem sogenannte grüne Keramikfolien beispielsweise im Siebdruckverfahren mit metallischen Pasten bedruckt werden. Die metallischen Pasten weisen z.B. AgPd- oder Cu-Partikel, Lösungsmittel und weitere Zuätze auf. Danach werden typischerweise ca. 300 bis 600 mit der Paste versehene grüne Keramikfolien übereinander gelegt und durch Pressen zu einem sogenannten Grünblock verarbeitet. Aus einem Grünblock z.B. der Größe von ca. 36mmx105mmx105mm, können etwa 100 einzelne vollaktive Piezostapel der Größe von ca. 36mmx9mmx9mm getrennt werden. Nach einem Entbindern und Sintern entstehen dann aus den grünen Keramikfolien die piezoelektrischen Schichten und aus den Pasten die Innenelektroden.

Schwierigkeiten ergeben sich bei der Verwendung eines vollaktiven Piezostapels bei der zuverlässigen alternierenden Kontaktierung der Innenelektroden mit den Außenelektroden, da ja alle Innenelektroden bis an die Außenseite des Piezostapels herangeführt sind und eine technologisch aufwendige Entfernung der Beschichtung auf jeder zweiten Innenelektrode kostenintensiv ist.

Erfindungsgemäß wird die Außenseite zumindest in den Bereichen, die den Außenelektroden zugeordnet sind, vollständig beschichtet. Diese Beschichtung kann insbesondere relativ dünn, z.B. im Bereich zwischen 0,1 und 5µm ausgeführt sein.

Damit die Innenelektroden zuverlässig die beiden Außenelektroden alternierend kontaktieren, haftet die Beschichtung erfindungsgemäß in bestimmten Bereichen nicht oder zumindest nur relativ schlecht. Diese Bereiche sind die ersten Bereiche der Innenelektroden, welche anschließend kontaktiert werden sollen.

Im zweiten Bereich der Innenelektroden haftet dagegen die Beschichtung gut. Somit ist es möglich, die Beschichtung vom ersten Bereich der Innenelektroden relativ einfach zu entfernen, bzw. die Beschichtung platzt selbständig ab. Zusätzlich können abgeplatzte Beschichtungsreste abgeblasen, oxidiert oder weggespült werden.

Durch das bevorzugt selbstständige Abplatzen der Beschichtung in den relevanten Bereichen liegen dort die leitfähigen Innenelektroden aus dem für die Beschichtung schlecht oder nicht haftenden Material frei und können anschließend mit den Außenelektroden kontaktiert werden.

Die Außenelektroden werden z.B. durch das Einschmieren einer metallischen Paste z.B. im Siebdruckverfahren aufgebracht. Andere Verfahren sind auch denkbar. So können die Außenelektroden auch auf die Beschichtung aufgebracht werden, indem eine leitfähige Außenmetallisierung über Abscheidungsprozesse aus der Gasphase erfolgt, wobei, ähnlich wie bei der Herstellung von Massenteilen für die Mikroelektronik, abdeckende Masken für die Bereiche des Piezostapels, die nicht mit der Außenmetallisierung versehen werden soll, eingesetzt werden.

Diese Variante des erfindungsgemäßen Verfahrens zeichnet sich durch eine kostengünstige und zuverlässige Herstellung des erfindungsgemäßen Piezoaktors aus.

Wenn die beiden Außenelektroden gemäß einer Ausführungsform des erfindungsgemäßen Verfahrens bzw. des erfindungsgemäßen Piezoaktors an zwei gegenüberliegenden Außenseiten des Piezostapels angeordnet sind, dann ist es möglich, den erfindungsgemäßen Piezoaktor einfach herzustellen, indem die ersten und zweiten Bereiche alternierend aufeinander folgender Innenelektroden jeweils zueinander um 180° gedreht sind.

Die Beschichtung weist z.B. eine amorphe Struktur auf und ist insbesondere eine DLC-Schicht. Eine sogenannte DLC ("Diamondlike carbon", diamantähnlicher Kohlenstoff) Schicht ist eine Kohlenstoff basierte Schicht, die sich z.B. mittels PVD oder CVD Verfahren auf die Außenseite des Piezostapels abscheiden lässt. DLC-Schichten weisen eine amorphe Struktur mit Ordnungszuständen im Nanometer-Bereich auf und werden auch als a-C ("amorphous carbon") Schichten bezeichnet. Sie können neben Kohlenstoff auch Wasserstoff enthalten und werden dann auch als a-C:H ("amorphous carbon hydrogen") Schichten bezeichnet.

DLC-Schichten sind Dünnschichten mit Schichtdicken im Bereich von kleiner als 10µm, in der Regel ca. zwischen 0,1µm und 5µm. Damit sich die amorphe Struktur ausbildet, wird die als DLC-Schicht ausgeführte Beschichtung z.B. relativ hohen Abkühlraten ausgesetzt und mit energiereichen Teilchen beschossen. Durch den Teilchenbeschuss treten Druckeigenspannungen und auf diese Weise die der DLC-Schicht ihren Namen gebenden diamantähnlichen Bindungsteile aus sp³-hybridisierten C-C-Bindungen auf. Ferner können sp³-hybridisierte C-C-Bindungen in verschiedenen Anordnungen vorkommen, z.B. zyklische oder lineare Formationen unterschiedlicher Größe in einer amorphen sp³-hybridisierten C-C-Matrix. Wenn die DLC-Schicht zusätzlich Wasserstoff enthält, dann weist die Beschichtung auch sp²/sp³-hybridisierte C-H-Anteile auf, die ab einem bestimmten Anteil des Wasserstoffs zu weicheren DLC-Schichten mit geringerer Dichte führen.

Ein Vorteil von DLC-Schichten ist es, dass diese aufgrund ihres Anteils an diamantähnlichen sp³-hybritisierten C-C-Bindungen eine relativ hohe Verschleißbeständigkeit aufweisen.

Amorphe Schichten mit einem relativ geringen oder gar keinen sp²-hybridisierten C-C-Cluster im Nahordnungsbereich weisen einen relativ hohen Isolationswiderstand auf. Derartige DLC-Schichten zählen zu den keramischen bzw. glasigen Werkstoffen. Da die Beschichtung einerseits die Innenelektroden von den Außenelektroden elektrisch isolieren sollen, muss die Struktur der DLC-Schicht geeignet gewählt werden. Insbesondere DLC-Schichten können durch Raman-Spektroskopie (zerstörungsfreie Prüfung geeignet für Grossserienproduktion) geprüft werden.

Auf Kohlenstoff basierte Schichten haben eine gute Haftung auf Karbidbildnern, weil sie eine hohe Affinität zu Kohlenstoff haben. Bei dem erfindungsgemäßen Piezoaktor und gemäss einer Variante des erfindungsgemäßen Verfahrens weisen die Innenelektroden in ihren zweiten Bereichen deshalb ein als Karbidbildner ausgebildetes Material auf. Geeignete Elemente für Karbidbildner sind z.B. Titan und Silizium, die auch häufig als Haftvermittler auf schlecht zu beschichtenden Substraten Verwendung finden.

Materialien, die keine Karbidbildner sind, lassen sich schlechter oder auch gar nicht beschichten. Beispielsweise sind Cu-Substrate mit dem PE-CVD-Verfahren der Gleichstromentladung nicht haftfest zu beschichten. Die Innenelektroden können daher in ihren ersten Bereichen Kupfer basierte Innenelektroden sein.

Nach einer Ausführungsform des erfindungsgemäßen Verfahrens werden die Innenelektroden durch Versehen der piezoelektrischen Schichten mit wenigstens zwei verschiedenen Elektrodenpasten hergestellt, von denen eine erste Elektrodenpaste dem ersten Bereich zugeordnet ist und eine schlechte oder keine Haftung für die Beschichtung bereitstellt und eine zweite Elektrodenpaste dem zweiten Bereich zugeordnet ist und eine gute Haftung für die Beschichtung bereitstellt.

Das erfindungsgemäße Verfahren ermöglicht die Herstellung eines Piezoaktors aus einem vollaktiven Piezostapel auf kostengünstige Weise. Aufgrund der Verwendung des vollaktiven Piezostapels für den erfindungsgemäßen Piezoaktor ergeben sich geringere mechanische Spannungen im Betrieb des erfindungsgemäßen Piezoaktors im Vergleich zu herkömmlichen Piezoaktoren mit konventionellen, inaktive Zonen aufweisenden Piezostapeln. Dadurch sind Vorraussetzungen für eine wesentlich längere Lebensdauer des erfindungsgemäßen Piezoaktors gegeben.

Ein Ausführungsbeispiel der Erfindung ist in den beigefügten schematischen Zeichnungen exemplarisch dargestellt. Es zeigen:
- Fig. 1: eine perspektivische Seitenansicht eines vollaktiven Piezostapels,
- Fig. 2: ein die Herstellung des Piezostapels und dessen Weiterverarbeitung veranschaulichendes Flussdiagramm,
- Fig. 3: eine Draufsicht einer Innenelektrode des Piezostapels,
- Fig. 4: einen Seitenschnitt des Piezostapels,
- Figs. 5, 6: Zwischenschritte bei der Herstellung des Piezostapels,
- Fig. 7: einen teilweise Seitenschnitt des mit einer Beschichtung versehenen Piezostapels,
- Fig. 8: einen teilweise Seitenschnitt des beschichteten Piezostapels nach einer Behandlung,
- Fig. 9: den vollaktiven Piezostapel mit zusätzlichen Auβenelektroden und
- Fig. 10: einen teilweise Seitenschnitt des mit Außenelektroden versehenen Piezostapels.

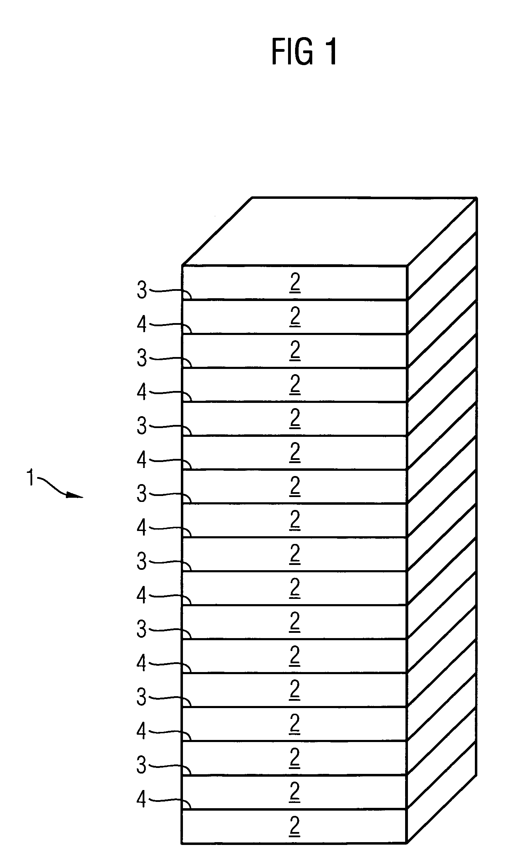

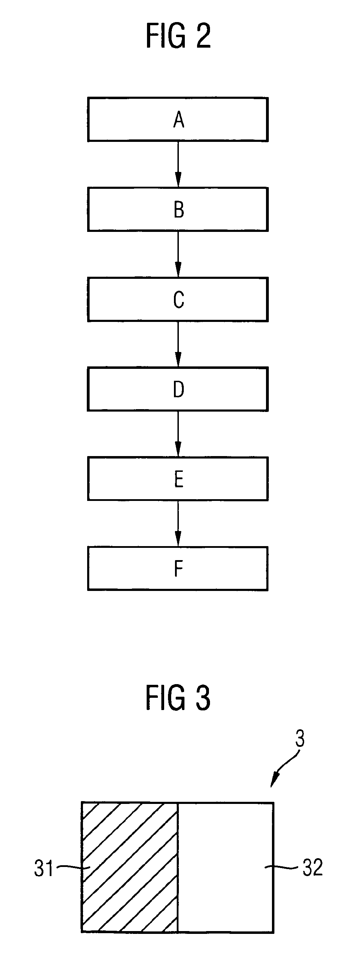

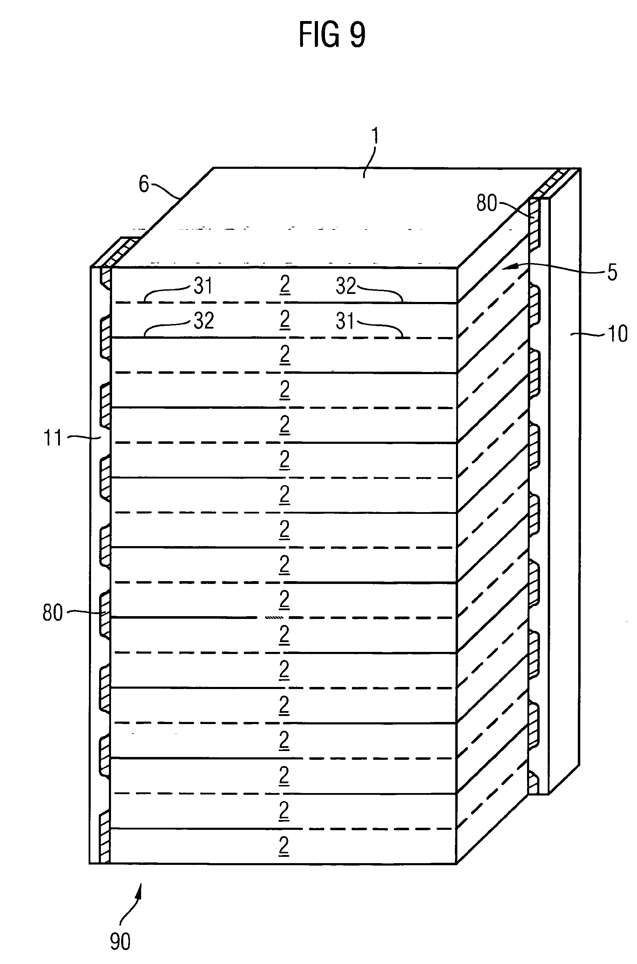

Die Fig. 1 zeigt einen im Falle des vorliegenden Ausführungsbeispiels quaderförmig ausgebildeten vollaktiven Piezostapel 1, der zu einem in der Fig. 9 gezeigten Piezoaktor 90 weiter verarbeitet werden soll, und die Fig. 2 zeigt ein Flussdiagramm, das die Herstellung des Piezostapels 1 und dessen Weiterverarbeitung veranschaulicht.

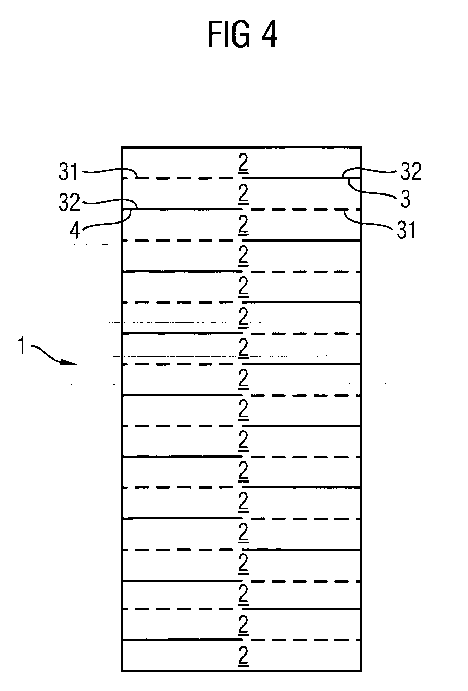

Der Piezostapel 1 weist mehrere piezoelektrische Schichten 2 auf, zwischen denen jeweils eine Innenelektrode 3, 4 angeordnet ist. Die Innenelektroden 3, 4 sind durchgehend ausgeführt und erstrecken sich bis an die Außenseiten des Piezostapels 1. Eine Draufsicht einer Innenelektrode 3 ist in der Fig. 3 und ein Seitenschnitt des Piezostapels 1 ist in der Fig. 4 dargestellt. Die Innenelektroden 4 sind im Wesentlichen genauso aufgebaut wie die Innenelektroden 3, sind jedoch im Falle des vorliegenden Ausführungsbeispiels gegenüber den Innenelektroden 3 um 180° gedreht.

Im Falle des vorliegenden Ausführungsbeispiels besitzt jede der Innenelektroden 3, 4 jeweils erste und zweite Bereiche 31, 32, wobei der erste Bereich 31 aus ein Material besteht, auf dem die beschriebene Beschichtung relativ schlecht oder gar nicht haftet, und der zweite Bereich 32 einem Material aufweist, an dem diese Beschichtung relativ gut haftet.

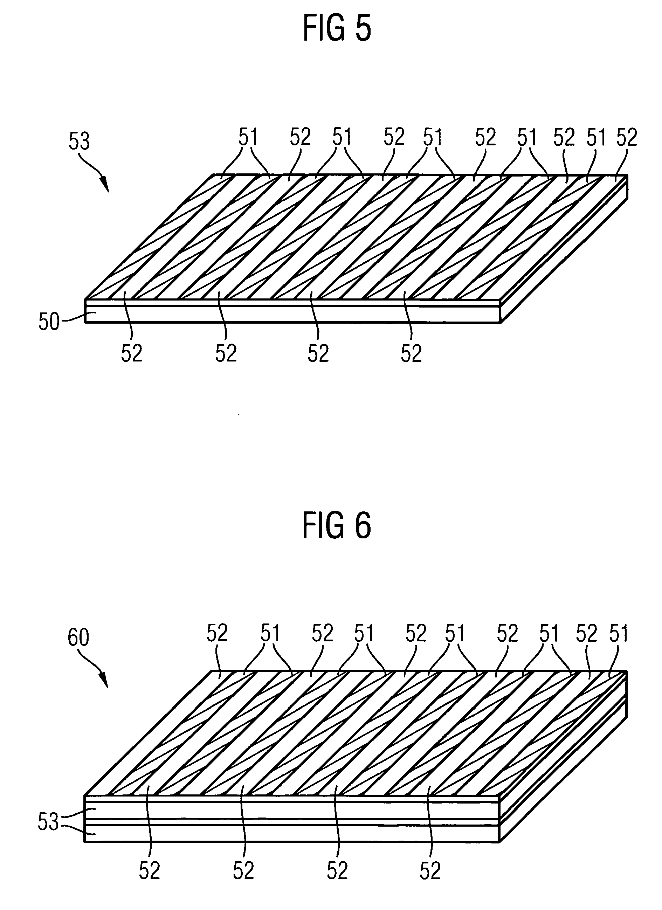

Im Falle des vorliegenden Ausführungsbeispiels wird der vollaktive Piezostapel 1 folgendermaßen hergestellt:
Zunächst wird auf eine in der Fig. 5 dargestellte sogenannte grüne Keramikfolien 50 mit beispielsweise einer Querschnittsfläche von 105mm×105mm streifenförmig erste und zweite Pasten 51, 52 z.B. im Siebdruckverfahren unter Zwischenschaltung eines Trocknungsschrittes nacheinander aufgebracht, Schritt A des Flussdiagramms der Fig. 2, wodurch ein Teilgrünblock 53 entsteht. -

Im Falle des vorliegenden Ausführungsbeispiels weist die erste Paste 51 Kupfer-Partikel und die zweite Paste 52 neben elektrisch leitfähigen Partikeln, beispielsweise Kupferpartikeln, Karbidbildner, wie z.B. Titan oder Silizium in Form von mikroskopisch fein verteilten Teilchen oder als submikroskopisch fein verteilte Vorstufen, auf. Ferner sind die Pasten 51, 52 derart auf der grünen Keramikfolie 50 aufgebracht, dass eine der Seiten mit einer der ersten Pasten 51 und die dazu gegenüber liegende Seite mit einer der zweiten Pasten 52 abgeschlossen ist. Aus den Pasten 51, 52 entstehen im Laufe des Herstellungsprozesses des Piezostapels 1 die Innenelektroden 3, 4, wobei die erste Paste 51 den ersten Bereichen 31 und die zweite Paste 52 den zweiten Bereichen 32 der Innenelektroden 3, 4 zugeordnet ist.

Anschließend werden mehrere, beispielsweise 300 bis 600 der mit den Pasten 51, 52 versehene Keramikfolien 50 (Teilgrünblock 53) übereinander gestapelt und gepresst, wodurch ein in der Fig. 6 nur teilweise dargestellter Grünblock 60 entsteht, Schritt B des Flussdiagramms. Der in der Fig. 6 teilweise dargestellte Grünblock 60 weist zwei übereinanderliegende Teilgrünblöcke 53 auf, wobei im Falle des vorliegenden Ausführungsbeispiels die einzelnen Teilgrünblöcke 53 alternierend um jeweils 180° bezüglich eines darauffolgenden Teilgrünblocks 53 gedreht sind.

Aus dem Grünblock 60 werden anschließend mehrere vollaktive Grünstapel herausgetrennt, aus denen durch Entbindern und Sintern die vollaktiven Piezostapel 1 entstehen, d.h. die Grünfolien 50 ergeben die piezoelektrischen Schichten 2 und die Pasten 51, 52 die Innenelektroden 3, 4, Schritt C des Flussdiagramms.

Der so entstandene Piezostapel 1 weist demnach an jeweils zwei gegenüberliegenden Außenseiten 5, 6 alternierende Innenelektroden 3, 4 auf, wobei alternierend an die Außenseiten ein schlecht bzw. nicht haftender erster Bereich 31 und ein gut haftender zweiter Bereich 32 der Innenelektroden 31, 32 grenzt.

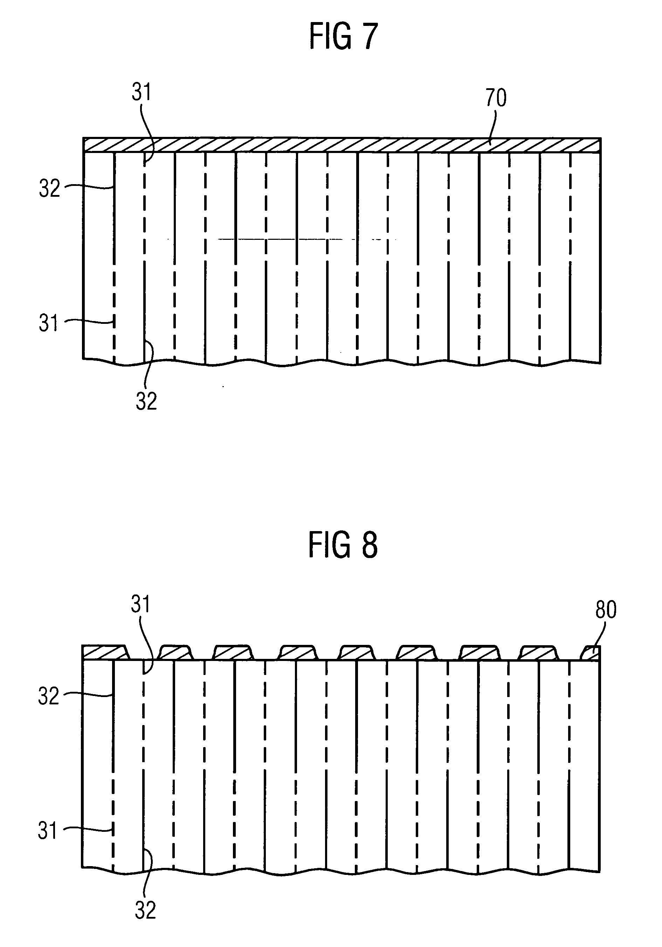

Anschließend wird der Piezostapel 1 mit einer in der Fig. 7 gezeigten vollständigen Beschichtung 70 zumindest in Bereichen der Außenseiten 5, 6 versehen, die in einem weiter unten beschriebenen Herstellungsschritt mit den Außenelektroden versehen wird, Schritt D des Flussdiagramms.

Im Falle des vorliegenden Ausführungsbeispiels handelt es sich bei der Beschichtung 70 um eine amorphe bzw. nano-kristalline oder kristalline Schicht oder insbesonders um eine Kohlenstoff-basierte Dünnschicht, eine DLC-Schicht, die beispielsweise durch ein PE-CVD Verfahren DC Plasmadekomposition aus einem Prekursor C₂H₂ oder CH₄ erzeugt wurde und insbesondere eine Dicke von 0,1 bis 5µm aufweist.

Dadurch, dass die zweiten Bereiche 32 der Innenelektroden 3, 4 aus den mit den Karbidbildnern versehenen Pasten 52 hervorgehen, haftet die Beschichtung 70 in den zweiten Bereichen 32 der Innenelektroden 3, 4 zugeordneten Bereichen der Außenseiten 5, 6 gut. In den ersten Bereichen 31 der Innenelektroden 3, 4 zugeordneten Bereichen der Außenseiten 5, 6 haftet dagegen die Beschichtung 70 schlecht bzw. gar nicht, wodurch die Beschichtung 70 in diesen Bereichen abplatzt, Schritt E des Flussdiagramms. Reste der abgeplatzten Beschichtung 70 können abgeblasen, weggespült oder oxidiert werden oder das Abblasen oder Wegspülen kann für ein verbessertes Abplatzen sorgen. Dadurch entsteht ein in der Fig. 8 in einer teilweisen Seitenansicht gezeigter Piezostapel 1 mit behandelter Beschichtung 80, bei dem einerseits auf jeder der beiden Außenseiten 5, 6 in den Bereichen der Beschichtung 80 alternierend eine Innenelektrode 3,4 freigelegt bzw. von der Beschichtung 80 bedeckt ist und andererseits für eine bestimmte der Innenelektroden 3, 4 diese im Bereich der Beschichtung 80 auf einer der Außenseite 5, 6 freigelegt und auf der gegenüberliegenden Außenseite 5, 6 durch die Beschichtung 80 überdeckt ist.

Anschließend werden die Beschichtungen 80 z.B. im Siebdruckverfahren gut mit einer elektrisch leitenden Paste versehen, die die Außenelektroden 10, 11 darstellen, Schritt F des Flussdiagramms. Aufgrund der Beschichtung 80 kontaktieren die Außenelektroden 10, 11 nur jede zweite Innelektroode 3, 4 und zwar in denen ersten Bereichen 31, in denn aufgrund der schlechten Haftung die Beschichtung 70 entfernt wurde.

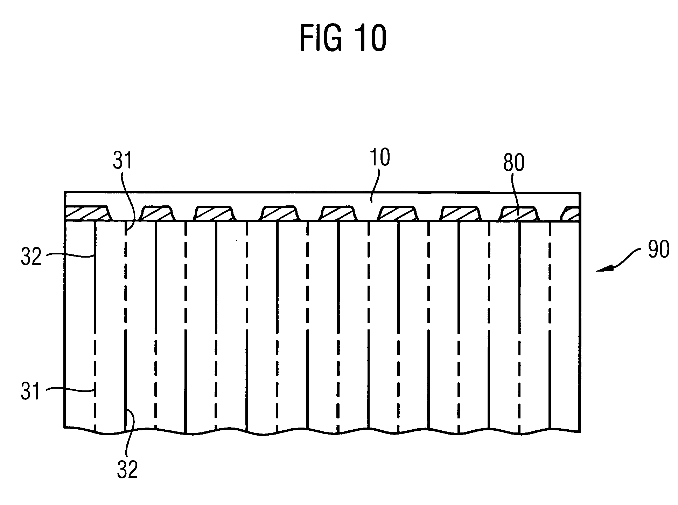

Somit entsteht ein in den Figuren 9 und 10 dargestellter Piezoaktor 90, der den Piezostapel 1 mit an seinen Außenseiten 5, 6 versehenen Beschichtungen 80 aufweist, wobei die Beschichtungen 80 in den ersten Bereichen 31 der Innenelektroden 3, 4 zugeordneten Bereichen nicht haftet, so dass die auf der Beschichtung 80 aufgetragenen Außenelektroden 10, 11 alternierend die Innenelektroden 3, 4 kontaktieren.

## Patentansprüche

1. Verfahren zum Herstellen eines Piezoaktors, aufweisend folgende Verfahrensschritte:
- Bereitstellen eines vollaktiven Piezostapels (1), der abwechselnd aufeinanderfolgende piezoelektrische Schichten (2) und bis an die Außenseite (5, 6) des Piezostapels (1) durchgehende Innenelektroden (3, 4) aufweist, wobei die Innenelektroden (3, 4) jeweils einen für eine Beschichtung (70) schlecht oder nicht haftenden ersten Bereich (31) und einen für die Beschichtung (80) gut haftenden zweiten Bereich (32) aufweisen und
vorgesehen sind, abwechselnd eine erste (10) und eine zweite Außenelektrode (11) des Piezoaktors (9) mit ihren ersten Bereichen (31) zu kontaktieren,
- vollständiges Beschichten der Außenseite (5, 6) des vollaktiven Piezostapels (1) mit der Beschichtung (70) zumindest in Bereichen, denen die Außenelektroden (10, 11) des Piezoaktors (9) zugeordnet sind,
- Entfernen der Beschichtung (70) in Bereichen, die an die ersten Bereiche (31) der Innenelektroden (3, 4) grenzen, und
- Auftragen der beiden Außenelektroden (10, 11) auf die Beschichtung (80), so dass die Außenelektroden (10, 11) die ersten Bereiche (31) der Innenelektroden (3, 4) kontaktieren und ansonsten zwischen den Innenelektroden (3, 4) und den Außenelektroden (10, 11) die Beschichtung (80) angeordnet ist.

2. Verfahren nach Anspruch 1,
**dadurch gekennzeichnet,**
**dass** der bereitgestellte Piezostapel (1) durch alternierendes Stapeln von wenigstens zwei Teilstapeln hergestellt wird, wobei jeder der Teilstapel eine piezoelektrische Schicht (2) und eine darauf angeordnete Innenelektrode (3, 4) aufweist.

3. Verfahren nach Anspruch 1 oder 2,
**gekennzeichnet durch**
Abblasen, Oxidieren und/oder Wegspülen von Beschichtungsresten der entfernten Beschichtung (70) vom Piezostapel (1).

4. Verfahren nach einem der Ansprüche 1 bis 3,
**dadurch gekennzeichnet,**
**dass** die ersten und zweiten Bereiche (31, 32) alternierend aufeinanderfolgender Innenelektroden (3, 4) jeweils zueinander um 180° gedreht sind.

5. Verfahren nach einem der Ansprüche 1 bis 4,
**dadurch gekennzeichnet,**
**dass** die Innenelektroden (3, 4) in ihren zweiten Bereichen (32) ein als Karbidbildner ausgebildetes Material aufweisen.

6. Verfahren nach einem der Ansprüche 1 bis 5,
**dadurch gekennzeichnet,**
**dass** die Innenelektroden (3, 4) durch Versehen der piezoelektrischen Schichten (2) mit wenigstens zwei verschiedenen Elektrodenpasten (51, 52) hergestellt werden, von denen eine erste Elektrodenpaste (51) dem ersten Bereich (31) zugeordnet ist und eine schlechte oder keine Haftung für die Beschichtung (70) bereitstellt und eine zweite Elektrodenpaste (52) dem zweiten Bereich (32) zugeordnet ist und eine gute Haftung für die Beschichtung (70, 80) bereitstellt.

7. Verfahren nach einem der Ansprüche 1 bis 6,
**dadurch gekennzeichnet,**
**dass** die Innenelektroden (3, 4) Kupfer aufweisen.

8. Verfahren nach einem der Ansprüche 1 bis 7,
**dadurch gekennzeichnet,**
**dass** die Beschichtung (70, 80) eine amorphe Struktur aufweist und eine DLC-Schicht oder eine Kohlenstoff-basierte Schicht ist.

9. Verfahren nach einem der Ansprüche 1 bis 8,
**dadurch gekennzeichnet,**
**dass** die Außenelektroden (10, 11) auf zwei gegenüberliegenden Außenseiten (5, 6) des Piezostapels (1) angeordnet sind.

10. Piezoaktor aufweisend
- erste und zweite Außenelektroden (10, 11),
- einen vollaktiven Piezostapel (1), der abwechselnd aufeinanderfolgende piezoelektrische Schichten (2) und bis an die Außenseite (5, 6) des Piezostapels (1) durchgehende Innenelektroden (3, 4) aufweist, wobei die Innenelektroden (3,4) jeweils einen fur eine Beschichtung (70) schlecht oder nicht haftenden ersten Bereich (31) und einen für die Beschichtung (80) gut haftenden zweiten Bereich (32) aufweisen, und abwechselnd die erste und die zweite Außenelektrode (10, 11) mit ihren ersten Bereichen (31) kontaktieren, **gekennzeichnet durch**
- eine auf der Außenseite (5, 6) des Piezostapels (1) angeordnete Beschichtung (80), auf der die Außenelektroden (10, 11) aufgetragen sind und die in Bereichen, in denen die Außenelektroden (10, 11) die Innenelektroden (3, 4) kontaktieren, entfernt ist, so dass die Außenelektroden (10, 11) die ersten Bereiche (31) der Innenelektroden (3, 4) kontaktieren und ansonsten zwischen den Innenelektroden (3, 4) und den Außenelektroden (10, 11) die Beschichtung (80) angeordnet ist,
- wobei die Innenelektroden (3, 4) in ihren zweiten Bereichen (32) ein als Karbidbildner ausgebildetes Material aufweisen.

11. Piezoaktor nach Anspruch 10,
**dadurch gekennzeichnet,**
**dass** die ersten und zweiten Bereiche (31, 32) alternierend aufeinanderfolgender Innenelektroden (3, 4) jeweils zueinander um 180° gedreht sind.

12. Piezoaktor nach einem der Ansprüche 10 bis 11,
**dadurch gekennzeichnet,**
**dass** die Innenelektroden (3, 4) als wenigstens zwei verschiedene Elektrodenpasten (51, 52) ausgeführt sind, mit denen die piezoelektrischen Schichten (2) versehen sind, von denen eine erste Elektrodenpaste (51) dem ersten Bereich (31) zugeordnet ist und eine schlechte oder keine Haftung für die Beschichtung (70) bereitstellt und von denen eine zweite Elektrodenpaste (52) dem zweiten Bereich (32) zugeordnet ist und eine gute Haftung für die Beschichtung (70, 80) bereitstellt.

13. Piezoaktor nach einem der Ansprüche 10 bis 12,
**dadurch gekennzeichnet,**
**dass** die Innenelektroden (3, 4) Kupfer aufweisen.

14. Piezoaktor nach einem der Ansprüche 10 bis 13,
**dadurch gekennzeichnet,**
**dass** die Beschichtung (70, 80) eine amorphe, nano-kristalline DLC-Schicht oder Kohlenstoff-basierte Schicht ist.

15. Piezoaktor nach einem der Ansprüche 10 bis 14,
**dadurch gekennzeichnet,**
**dass** die Außenelektroden (10, 11) auf zwei gegenüberliegenden Außenseiten (5, 6) des Piezostapels (1) angeordnet sind.

## Claims

1. Method for producing a piezo actuator, having the following method steps:
- provision of a fully active piezo stack (1), which has alternately successive piezoelectric layers (2) and internal electrodes (3, 4) which penetrate as far as the outer side (5, 6) of the piezo stack (1), wherein the internal electrodes (3, 4) each have a first region (31) which adheres poorly, or does not adhere, to a coating (70), and a second region (32) which adheres well to the coating (80), and are provided for alternately making contact with a first external electrode (10) and a second external electrode (11) of the piezo actuator (9), with their first regions (31),
- complete coating of the outer side (5, 6) of the fully active piezo stack (1) with the coating (70) at least in regions to which the external electrodes (10, 11) of the piezo actuator (9) are assigned,
- removal of the coating (70) in regions which adjoin the first regions (31) of the internal electrodes (3, 4), and
- application of the two external electrodes (10, 11) to the coating (80), with the result that the external electrodes (10, 11) make contact with the first regions (31) of the internal electrodes (3, 4) and otherwise the coating (80) is arranged between the internal electrodes (3, 4) and the external electrodes (10, 11).

2. Method according to Claim 1,
**characterized**
**in that** the piezo stack (1) which is provided is produced by alternately stacking at least two partial stacks, wherein each of the partial stacks has a piezoelectric layer (2) and an internal electrode (3, 4) arranged thereon.

3. Method according to Claim 1 or 2,
**characterized by**
blowing off, oxidizing and/or rinsing away coating residues of the removed coating (70) from the piezo stack (1).

4. Method according to one of Claims 1 to 3,
**characterized**
**in that** the first and second regions (31, 32) of alternately successive internal electrodes (3, 4) are respectively rotated through 180° with respect to one another.

5. Method according to one of Claims 1 to 4,
**characterized**
**in that** the internal electrodes (3, 4) have, in their second regions (32), a material which is embodied as a carbide former.

6. Method according to one of Claims 1 to 5,
**characterized**
**in that** the internal electrodes (3, 4) are produced by providing the piezoelectric layers (2) with at least two different electrode pastes (51, 52), a first electrode paste (51) of which is assigned to the first region (31) and provides poor adhesion, or no adhesion, to the coating (70), and a second electrode paste (52) is assigned to the second region (32) and provides good adhesion to the coating (70, 80).

7. Method according to one of Claims 1 to 6,
**characterized**
**in that** the internal electrodes (3, 4) have copper.

8. Method according to one of Claims 1 to 7,
**characterized**
**in that** the coating (70, 80) has an amorphous structure and is a DLC layer or a carbon-based layer.

9. Method according to one of Claims 1 to 8,
**characterized**
**in that** the external electrodes (10, 11) are arranged on two opposite outer sides (5, 6) of the piezo stack (1).

10. Piezo actuator having
- first and second external electrodes (10, 11),
- a fully active piezo stack (1) which has alternately successive piezoelectric layers (2) and internal electrodes (3, 4) which penetrate as far as the outer side (5, 6) of the piezo stack (1), wherein the internal electrodes (3, 4) each have a first region (31) which adheres poorly, or does not adhere, to a coating (70), and a second region (32) which adheres well to the coating (80), and alternately make contact with the first external electrode (10) and the second external electrode (10, 11), with their first regions (31), **characterized by**
- a coating (80) which is arranged on the outer side (5, 6) of the piezo stack (1) and to which the external electrodes (10, 11) are applied and which is removed in regions in which the external electrodes (10, 11) make contact with the internal electrodes (3, 4), with the result that the external electrodes (10, 11) make contact with the first regions (31) of the internal electrodes (3, 4), and otherwise the coating (80) is arranged between the internal electrodes (3, 4) and the external electrodes (10, 11),
- wherein the internal electrodes (3, 4) have, in their second regions (32), a material which is embodied as a carbide former.

11. Piezo actuator according to Claim 10,
**characterized**
**in that** the first and second regions (31, 32) of alternately successive internal electrodes (3, 4) are respectively rotated through 180° with respect to one another.

12. Piezo actuator according to one of Claims 10 to 11,
**characterized**
**in that** the internal electrodes (3, 4) are embodied as at least two different electrode pastes (51, 52) with which the piezoelectric layers (2) are provided, a first electrode paste (51) of which electrode pastes (51, 52) is assigned to the first region (31) and provides poor adhesion, or no adhesion, to the coating (70), and a second electrode paste (52) of which electrode pastes (51, 52) is assigned to the second region (32) and provides good adhesion to the coating (70, 80).

13. Piezo actuator according to one of Claims 10 to 12,
**characterized**
**in that** the internal electrodes (3, 4) have copper.

14. Piezo actuator according to one of Claims 10 to 13,
**characterized**
**in that** the coating (70, 80) is an amorphous, nanocrystalline DLC layer or carbon-based layer.

15. Piezo actuator according to one of Claims 10 to 14,
**characterized**
**in that** the external electrodes (10, 11) are arranged on two opposite outer sides (5, 6) of the piezo stack (1).

## Revendications

1. Procédé de fabrication d'un actionneur piézoélectrique, présentant les étapes de procédé suivantes consistant à :
- préparer un empilement piézoélectrique (1) entièrement actif, qui présente en alternance des couches piézoélectriques (2) successives et des électrodes internes (3, 4) s'étendant jusqu'à la face externe (5, 6) de l'empilement piézoélectrique (1), dans lequel les électrodes internes (3, 4) présentent respectivement une première zone (31) adhérant mal ou n'adhérant pas à un revêtement (70) et une deuxième zone (32) adhérant bien au revêtement (80) et sont prévues pour venir en contact en alternance avec une première (10) et une seconde électrode externe (11) de l'actionneur piézoélectrique (9) par leurs premières zones (31),
- à revêtir complètement la face externe (5, 6) de l'empilement (1) entièerement actif par le revêtement (70) au moins dans des zones auxquelles les électrodes externes (10, 11) de l'actionneur piézoélectrique (9) sont affectées,
- retirer le revêtement (70) dans les zones qui sont adjacentes aux premières zones (31) des électrodes internes (3, 4), et
- appliquer les deux électrodes externes (10, 11) sur le revêtement (80) de sorte que les électrodes externes (10, 11) viennent en contact avec les premières zones (31) des électrodes internes (3, 4) et que sinon le revêtement (80) soit agencé entre les électrodes internes (3, 4) et les électrodes externes (10, 11).

2. Procédé selon la revendication 1,
**caractérisé en ce que**
l'empilement piézoélectrique (1) préparé est fabriqué par empilement alterné d'au moins deux empilements partiels, dans lequel chacun des empilements partiels présente une couche piézoélectrique (2), sur laquelle est agencée une électrode interne (3, 4).

3. Procédé selon la revendication 1 ou 2,
**caractérisé par**
le soufflage, l'oxydation et/ou le rinçage de restes du revêtement retiré (70) de l'empilement piézoélectrique (11).

4. Procédé selon l'une quelconque des revendications 1 à 3,
**caractérisé en ce que**
les premières et deuxièmes zones (31, 32) des électrodes internes (3, 4) alternées successives sont tournées de 180 ° les unes par rapport aux autres.

5. Procédé selon l'une quelconque des revendications 1 à 4,
**caractérisé en ce que**
les électrodes internes (3, 4) présentent dans leurs deuxièmes zones (32) un matériau sous la forme d'un générateur de carbure.

6. Procédé selon l'une quelconque des revendications 1 à 5,
**caractérisé en ce que**
les électrodes internes (3, 4) sont fabriquées en munissant les couches piézoélectriques (2) d'au moins deux pâtes d'électrode différentes (51, 52), parmi lesquelles une première pâte d'électrode (51), est affectée à la première zone (31) et adhère mal ou n'adhère pas au revêtement (70), et une deuxième pâte d'électrode (52) est affectée à la deuxième zone (32) et présente une bonne adhérence pour le revêtement (70, 80).

7. Procédé selon l'une quelconque des revendications 1 à 6,
**caractérisé en ce que**
les électrodes internes (3, 4) comprennent du cuivre.

8. Procédé selon l'une quelconque des revendications 1 à 7,
**caractérisé en ce que**
le revêtement (70, 80) présente une structure amorphe et est une couche DLC ou une couche à base de carbone.

9. Procédé selon l'une quelconque des revendications 1 à 8,
**caractérisé en ce que**
les électrodes externes (10, 11) sont agencées sur deux faces externes (5, 6) opposées de l'empilement piézoélectrique (1).

10. Actionneur piézoélectrique présentant :
- une première et une deuxième électrode externe (10, 11),
- un empilement piézoélectrique (1) entièrement actif, qui présente en alternance des couches piézoélectriques (2) successives et des électrodes internes (3, 4) s'étendant jusqu'à la face externe (5, 6) de l'empilement piézoélectrique (1), dans lequel les électrodes internes (3, 4) présentent respectivement une première zone (31) adhérant mal ou n'adhérant pas à un revêtement (70) et une deuxième zone (32) adhérant bien au revêtement (80) et sont en contact en alternance avec des premières et des secondes électrodes externes (10, 11) par leurs premières zones (31),
**caractérisé en ce que** :
- un revêtement (80) appliqué sur la face externe (5, 6) de l'empilement piézoélectrique (1), revêtement sur lequel les électrodes externes (10, 11) sont appliquées et qui est retiré dans les zones dans lesquelles les électrodes externes (10, 11) viennent en contact avec les électrodes internes (3, 4) de sorte que les électrodes externes (10, 11) viennent en contact avec les premières zones (31) des électrodes internes (3, 4) et que sinon le revêtement (80) soit agencé entre les électrodes externes (10, 11) et les électrodes internes (3, 4),
- dans lequel les électrodes internes (3, 4) présentent dans leurs deuxièmes zones (32) un matériau sous la forme d'un générateur de carbure.

11. Actionneur piézoélectrique selon la revendication 10,
**caractérisé en ce que** :
les premières et les deuxièmes zones (31, 32) d'électrodes internes (3, 4) alternées successives sont tournées de 180 ° les unes par rapport aux autres.

12. Actionneur piézoélectrique selon l'une quelconque des revendications 10 à 11,
**caractérisé en ce que** :
les électrodes internes (3, 4) sont fabriquées sous la forme d'au moins deux pâtes d'électrode différentes (51, 52), dont sont pourvues les couches piézoélectriques (2) et parmi lesquelles une première pâte d'électrode (51) est affectée à la première zone (31) et adhère mal ou n'adhère pas au revêtement (70), et une deuxième pâte d'électrode (52) est affectée à la deuxième zone (32) et présente une bonne adhérence pour le revêtement (70, 80).

13. Actionneur piézoélectrique selon l'une quelconque des revendications 10 à 12,
**caractérisé en ce que**
les électrodes internes (3, 4) comprennent du cuivre.

14. Actionneur piézoélectrique selon l'une quelconque des revendications 10 à 13,
**caractérisé en ce que**
le revêtement (70, 80) est une couche DLC nanocristalline amorphe ou une couche à base de carbone.

15. Actionneur piézoélectrique selon l'une quelconque des revendications 10 à 14,
**caractérisé en ce que**
les électrodes externes (10, 11) sont agencées sur deux faces externes (5, 6) opposées de l'empilement piézoélectrique (1).
